## Europäisches Patentamt

## European Patent Office

## Office européen des brevets

(19)

(11) Veröffentlichungsnummer: **0 248 155**
**B1**

# EUROPÄISCHE PATENTSCHRIFT

(45) Veröffentlichungstag der Patentschrift:
**11.07.90**

(51) Int. Cl.⁵: **G01R 33/30**

(21) Anmeldenummer: **87104009.3**

(22) Anmeldetag: **18.03.87**

(54) **Antenneneinrichtung zum Anregen und/oder Empfangen hochfrequenter Felder in einer Kernspintomographie-Apparatur.**

(30) Priorität: **20.05.86 DE 3616705**

(43) Veröffentlichungstag der Anmeldung:
**09.12.87 Patentblatt 87/50**

(45) Bekanntmachung des Hinweises auf die Patenterteilung:
**11.07.90 Patentblatt 90/28**

(84) Benannte Vertragsstaaten:
**DE FR GB NL**

(56) Entgegenhaltungen:
**EP-A- 0 073 375**
**EP-A- 0 153 531**
**EP-A- 0 156 042**
**EP-A- 0 180 121**

(73) Patentinhaber: **Siemens Aktiengesellschaft,
Wittelsbacherplatz 2, D-8000 München 2(DE)**

(72) Erfinder: **Oppelt, Ralph, Dr., Lindenweg 1,
D-8525 Uttenreuth(DE)**
Erfinder: **Dürr, Wilhelm, Dr., Damaschkestrasse 99,
D-8520 Erlangen(DE)**

## Beschreibung

Die Erfindung bezieht sich auf eine Antenneneinrichtung zur Anregung eines zumindest weitgehend homogenen magnetischen Hochfrequenzfeldes und/oder zum Empfangen von entsprechenden hochfrequenten Signalen in einer Kernspintomographie-Apparatur mit

– einer hohlzylinderförmigen Leiterhülle, die zumindest weitgehend niederfrequenzdurchlässig für magnetische Gradientenfelder ausgebildet ist,
– mindestens zwei gegensinnig stromdurchflossenen Leitereinheiten, die sich innerhalb der Leiterhülle in Längsrichtung der Einrichtung erstrecken und jeweils ein Leiterelement oder eine Leitergruppe enthalten,
– die Wellen des Hochfrequenzfeldes reflektierenden Mitteln an ihren stirnseitigen Enden und
– einer externen Energieeinspeisungs- bzw. Empfangsvorrichtung.

Diese Antenneneinrichtung ist aus dem europäischen Patent 0 073 375 bekannt.

Auf dem Gebiet der medizinischen Technik sind bildgebende Diagnoseverfahren entwickelt worden, bei denen rechnerisch oder meßtechnisch integrale Resonanzsignale von Kernen eines bestimmten chemischen Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich einem Röntgentomogramm der Computertomographie konstruieren. Entsprechende Verfahren sind unter der Bezeichnung "Kernspintomographie" (bzw. Nuclear Magnetic Resonance Tomography-NMR-Tomographie) oder "Zeugmatographie" bekannt.

Für die Kernspintomographie ist ein von einem sogenannten Grundfeldmagneten erzeugtes starkes Magnetfeld Voraussetzung, das in einem Abbildungs- bzw. Untersuchungsbereich hinreichend homogen sein muß. In diesen Bereich wird ein zu untersuchender Körper bzw. Körperteil längs einer Achse, die im allgemeinen mit der Orientierungsachse des magnetischen Grundfeldes übereinstimmt, eingebracht. Dieses Grundfeld ist von stationären und/oder gepulsten, sogenannten Gradientenfeldern überlagert. Zur Anregung der einzelnen Atomkerne in dem Körper bzw. Körperteil zu einer Präzessionsbewegung ist außerdem eine besondere Antenneneinrichtung erforderlich, mit der kurzzeitig ein hochfrequentes magnetisches Wechselfeld (HF-Feld) hinreichender Homogenität angeregt werden kann. Gegebenenfalls läßt sich diese Antenneneinrichtung auch zum Empfang der so hervorgerufenen hochfrequenten Signale vorsehen.

Mit der aus der eingangs genannten Patentschrift bekannten HF-Antenneneinrichtung können HF-Felder mit hohen Frequenzen von 20 MHz und mehr angeregt bzw. empfangen werden. Hierzu enthält die Antenneneinrichtung einen äußeren, hochzylinderförmigen Antennenteil aus elektrisch gut leitendem, nicht-magnetischem Material. Dieser Antennenteil stellt eine Leiterhülle um mehrere, mindestens ein Leiterpaar bildende innere Leiterelemente dar, die auf einer Zylinderfläche liegen, die von der Hülle konzentrisch in vorbestimmtem Abstand umgeben ist. Auf den mindestens zwei inneren, im sogenannten Gegentaktmode betriebenen Leiterelementen und der Leiterhülle werden dann für eine Wellenausbreitung mit der sehr hohen Frequenz λ/2-Resonanzverhältnisse eingestellt, wobei im gesamten interessierenden Untersuchungsvolumen gleichphasig schwingende Felder in Form von auf den Leitern stehenden Wellen ausgebildet werden. Hierzu sind Anfang und Ende der beiden inneren Leiterelemente durch die Wellen des HF-Feldes reflektierende Mittel wie z.B. vorbestimmte Kapazitäten symmetrisch elektrisch verkürzt.

Da ferner bei der bekannten Antenneneinrichtung der äußere, eine gemeinsame Leiterhülle um die inneren Leiterelemente bildende Antennenteil so ausgeführt ist, daß er zumindest weitgehend niederfrequenzdurchlässig ist, können sich in dem Untersuchungsvolumen die niederfrequenten Gradientenfelder entsprechend ungehindert ausbreiten.

Betrachtet man nun die sich längs der Leiterelemente bei der gewünschten λ/2-Resonanz einstellende Stromverteilung, so ist eine allmähliche, bezüglich der Leitermitte symmetrische Abnahme des Stromes zu den stirnseitigen Leiterenden hin festzustellen. D.h., eine entsprechende Stromverteilungskurve in einem Diagramm hat einen etwa kosinusförmigen Verlauf. Will man nun bei gleichbleibender axialer Länge der Antenneneinrichtung höhere Resonanzfrequenzen bzw. kürzere Wellenlängen vorsehen, so ist eine entsprechend geringere elektrische Verkürzung erforderlich. Dies führt aber dazu, daß der Stromabfall längs der Leiterelemente zu den Resonatorenden hin immer stärker ausgeprägt ist. Ein stärkerer Stromabfall ist jedoch im Interesse einer guten Feldhomogenität unerwünscht.

Eine solche inhomogene Stromverteilung kann man z.B. gemäß der DE-A 3 347 597 zumindest teilweise dadurch kompensieren, daß man die stabförmigen inneren Leiterelemente tonnenförmig verbiegt, so daß ihr Abstand zu einer äußeren hohlzylindrischen Leiterhülle an den Resonatorenden größer ist als in der Resonatormitte (vgl. Figur 15). Die entsprechende Formgebung der inneren Leiterelemente sowie deren exakte Anordnung innerhalb der äußeren Leiterhülle ist jedoch verhältnismäßig aufwendig.

Aufgabe der vorliegenden Erfindung ist es deshalb, die Antenneneinrichtung der eingangs genannten Art dahingehend zu verbessern, daß durch eine einfache Ausgestaltung und Anordnungsmöglichkeit der Leiterelemente die erwähnte inhomogene Stromverteilung zumindest weitgehend eliminiert ist.

Eine aus EP-A 0 153 531 bekannte Lösung dieser Aufgabe besteht darin, daß ein Teil der am Umfang einander benachbarten Leiterelemente verschiedene Durchmesser aufweist.

Gemäß der Erfindung besteht nun eine weitere Lösung in den Gestaltungsmerkmalen gemäß dem Hauptanspruch. Die mit dieser Ausgestaltung der jeweils aus einem oder mehreren Leiterelementen bestehenden Leitereinheiten verbundenen Vorteile

EP 0 248 155 B1

sind insbesondere darin zu sehen, daß mit der besonderen Graduierung des Leiterquerschnittes auf einfache Weise der Wellenwiderstand zwischen der Leitereinheit und der sie umgebenden hohlzylindrischen Leiterhülle entsprechend zu variieren ist. Damit läßt sich eine homogenere Stromverteilung erreichen, indem – bei gleichbleibender Phasengeschwindigkeit – der Wellenwiderstand zwischen diesen Teilen der Antenneneinrichtung zu den stirnseitigen Enden hin aufgrund einer entsprechenden Abnahme des Leiterquerschnittes zunimmt. Darüber hinaus sind die einzelnen Leiterelemente einfach vorzufertigen und ohne Schwierigkeit innerhalb der hohlzylindrischen Leiterhülle exakt anzuordnen.

Vorteilhafte Ausgestaltungen der erfindungsgemäßen Antenneneinrichtung gehen aus den Unteransprüchen hervor.

Zur weiteren Erläuterung der Erfindung wird nachfolgend auf die Zeichnung Bezug genommen, in deren Figuren 1 und 2 schematisch eine bekannte Antenneneinrichtung bzw. die dazugehörige Stromverteilung längs einer Leitereinheit wiedergegeben sind. Demgegenüber zeigt Figur 3 schematisch eine gemäß der Erfindung ausgestaltete Antenneneinrichtung.

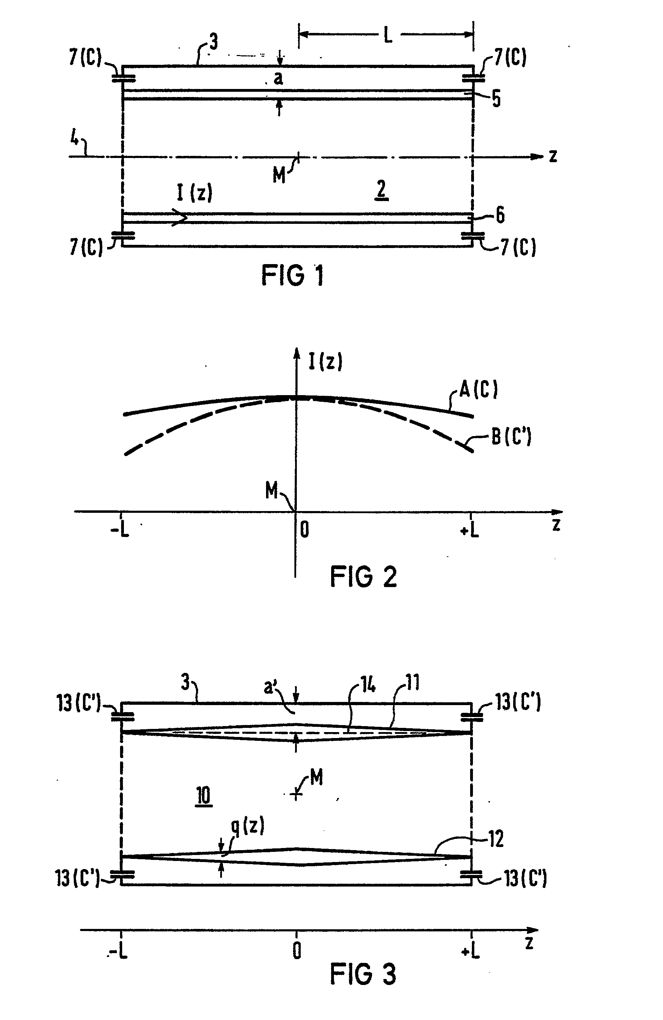

In Figur 1 ist schematisch ein Längsschnitt durch eine HF-Antenneneinrichtung wiedergegeben, wie sie aus der DE-A 3 133 432 bekannt ist. Diese allgemein mit 2 bezeichnete Antenneneinrichtung enthält eine Leiterhülle 3 aus elektrisch leitendem Material, die bezüglich einer in Richtung einer z-Koordinate weisenden Zylinderachse 4 hohlzylindrisch ausgebildet und für magnetische Gradientenfelder niederfrequenzdurchlässig ist. Dieser Antennenteil umhüllt mehrere, mindestens ein Leiterpaar bildende Leitereinheiten. Gemäß dem gewählten Ausführungsbeispiel sollen diese Leitereinheiten jeweils nur aus einem einzigen Leiterelement bestehen. Man kann aber auch Leitereinheiten aus Gruppen von Leiterelementen vorsehen. In der Figur sind zwei gerade, stangenartige Leiterelemente 5 und 6 ersichtlich, die auf einer gedachten, konzentrisch die Zylinderachse 4 umschließenden Zylindermantelfläche diametral gegenüberliegend angeordnet sind. Der konstante Abstand zwischen dieser Zylindermantelfläche und der dazu konzentrischen Leiterhülle 3 ist mit a bezeichnet. Die Leiterelemente 5 und 6 mit etwa gleicher axialer Länge 2L wie die sie umschließende äußere Leiterhülle 3 sind an ihren stirnseitigen Enden mit Kapazitäten, insbesondere Kondensatoren 7 der Größe C, an die Leiterhülle angekoppelt. Es ergibt sich so ein bezüglich der Mitte M symmetrisch kapazitiv verkürzter λ/2-Resonator der Länge 2L. Der im Resonanzfall durch die Leiterelemente 5 und 6 fließende Strom ist mit I bezeichnet.

Die Abhängigkeit dieses Stromes I von der jeweiligen Ortskoordinate z längs der Achse 4 ist aus dem Diagramm der Figur 2 ersichtlich. Dabei ist der Ursprung der Ortskoordinate z in die axiale Mitte M der Antenneneinrichtung gelegt. Bei einer bestimmten Resonanzfrequenz $f_1$, für die die Antenneneinrichtung zunächst ausgelegt ist, ergibt sich dann eine Stromverteilung I(z) längs einer Leitereinheit mit einem Kurvenverlauf A(C), der unter anderem von der Resonanzfrequenz $f_1$ und der Kapazität C abhängig ist. Wählt man nun für die in Figur 1 angedeutete Antenneneinrichtung Verkürzungskapazitäten C' mit kleineren Werten, so ergibt sich eine neue Resonanzfrequenz $f_2$, die größer als die ursprüngliche Resonanzfrequenz $f_1$ ist. Für diese neue Resonanzfrequenz $f_2$ stellt sich in den einzelnen Leiterelementen eine Stromverteilung I(z) ein, die durch den in Figur 2 gestrichelt eingezeichneten Kurvenverlauf B(C') beschrieben wird. Bei einem Vergleich dieses Kurvenverlaufs mit dem Kurvenverlauf A(C) läßt sich ohne weiteres erkennen, daß zunehmender Resonanzfrequenz der Stromabfall zu den stirnseitigen Enden bei z = +L bzw. z = –L der Antenneneinrichtung hin immer stärker wird. Dieser unerwünschte Effekt läßt sich mit den erfindungsgemäßen Maßnahmen zumindest weitgehend kompensieren.

Ein entsprechendes Ausführungsbeispiel einer Antenneneinrichtung gemäß der Erfindung geht aus Figur 3 hervor, wobei eine Figur 1 entsprechende Darstellung gewählt ist. Diese erfindungsgemäße, allgemein mit 10 gekennzeichnete HF-Antenneneinrichtung weist ebenfalls die an sich bekannte, insbesondere in der EP-A 0 073 375 näher ausgeführte Leiterhülle 3 auf. Sie unterscheidet sich im wesentlichen von der bekannten Einrichtung durch die besondere Ausgestaltung ihrer Leitereinheiten. In dieser Ausführungsform werden die Leitereinheiten jeweils durch ein einziges gerades Leiterelement gebildet, von denen in der Figur die beiden diametral einander gegenüberliegenden Leiterelemente 11 und 12 ersichtlich sind. Sie sind ebenfalls mittels Kondensatoren 13, beispielsweise mit Kapazitäten C' gemäß Figur 2, an ihren bei z = +L und z = –L liegenden stirnseitigen Enden symmetrisch bzgl. ihrer bei z = 0 liegenden Mitte H elektrisch verkürzt. Diese Leiterelemente haben jeweils einen Querschnitt q(z), der sich von ihrer Mitte zu ihren beiden stirnseitigen Enden hin vorzugsweise symmetrisch verjüngt. Die Leiterelemente 11 und 12 haben somit eine leicht doppelkegelförmige Gestalt. Ihre durch eine gestrichelte Linie angedeuteten Mittenachsen 14 haben dabei vorzugsweise einen konstanten Abstand a' von der Leiterhülle 3.

Mit einer solchen Verjüngung des Leiterquerschnittes wird vorteilhaft erreicht, daß der Wellenwiderstand zwischen dem einzelnen Leiterelement und der es umgebenden äußeren Leiterhülle nach den stirnseitigen Enden hin zunimmt. Die Stromabnahme längs der Leiterelemente zu diesen Enden hin ist dann entsprechend geringer, d.h. die longitudinale Feldhomogenität wird so verbessert.

Gemäß dem in Figur 3 dargestellten Ausführungsbeispiel wurde davon ausgegangen, daß die einzelnen Leiterelemente innerhalb der Leiterhülle leicht kegelförmige Gestalt haben. Ebensogut können jedoch auch andere Leiterformen gewählt werden, bei denen eine kontinuierliche oder auch in diskreten Abstufungen vorgenommene Abnahme des Querschnittes an elektrisch leitendem Material gewährleistet ist. So können beispielsweise auch Streifenleiter als Leiterelemente vorgesehen werden, deren Breite in entsprechender Weise nach den Enden hin abnimmt. Die jeweilige Leiterbreite und die Stärke (Dicke) der Streifen legen dabei den elektrisch leitenden Querschnitt q(z) fest.

Um keine Störungen der Gradientenfelder zu verursachen, genügt es auch, daß man nur die Oberflächen der Leiterelemente aus leitfähigem Material ausbildet.

Die inneren Leitereinheiten können auch durch Gruppen aus mehreren parallelgeschalteten Leiterelementen gebildet sein. Die Querschnittsänderung gemäß der Erfindung braucht sich dabei nicht auf alle Leiterelemente einer solchen Leitereinheit zu beziehen, sondern es können auch nur einzelne Leiterelemente einer Leitereinheit in ihrem Querschnitt graduiert sein, während die übrigen Leiterelemente konstanten Leiterquerschnitt aufweisen. D.h., für eine Abnahme des Leiterquerschnittes ist stets der Gesamtquerschnitt der jeweiligen Leitereinheit zu betrachten.

Darüber hinaus ist es möglich, die Querschnittsvariation der inneren Leiterelemente noch mit der aus der DE–A 3 347 597 (Figur 15) bekannten Abstandsvariation zu kombinieren. In diesem Falle wären also z.B. für die Ausführungsform nach Figur 3 die Mittenachsen 14 der Leiterelemente so tonnenartig gewölbt, daß sie im Bereich der axialen Mitte (z = 0) der Antenneneinrichtung 10 einen geringeren Abstand 8, gegenüber der Leiterhülle 3 haben als in den Bereichen ihrer stirnseitigen Enden (z = +L und z = –L).

## Patentansprüche

1. Antenneneinrichtung zur Anregung eines zumindest weitgehend homogenen magnetischen Hochfrequenzfeldes und/oder zum Empfang von entsprechenden hochfrequenten Signalen in einer Kernspintomographie-Apparatur mit
— einer hohlzylinderförmigen Leiterhülle (3), die zumindest weitgehend niederfrequenzdurchlässig für magnetische Gradientenfelder ausgebildet ist,
— mindestens zwei gegensinnig stromdurchflossenen Leitereinheiten, die sich innerhalb der Leiterhülle (3) in Längsrichtung der Einrichtung erstrecken und jeweils ein Leiterelement oder eine Leitergruppe enthalten,
— die Wellen des Hochfrequenzfeldes reflektierenden Mitteln an ihren stirnseitigen Enden und
— einer externen Energieeinspeisungs- und Empfangsvorrichtung, dadurch gekennzeichnet, daß die Leiterelemente (11, 12) der Leitereinheiten mindestens zum Teil einen Querschnitt (q) aufweisen, der von der axialen Mitte (z = 0) nach den stirnseitigen Enden (z = +L bzw. z = –L) hin zumindest weitgehend symmetrisch abnimmt.

2. Antenneneinrichtung nach Anspruch 1, dadurch gekennzeichnet, daß eine kontinuierliche und/oder stufenweise Abnahme des elektrisch leitenden Querschnittes (q) der Leiterelemente (11, 12) vorgesehen ist.

3. Antenneneinrichtung nach Anspruch 1 oder 2, dadurch gekennzeichnet, daß die Leiterelemente (11, 12) doppelkegelförmig gestaltet sind.

4. Antenneneinrichtung nach Anspruch 1 oder 2, dadurch gekennzeichnet, daß die Leiterelemente streifenförmig ausgebildet sind.

5. Antenneneinrichtung mit Leitereinheiten aus jeweils mehreren, zu einer Gruppe zusammengefaßten Leiterelementen, nach einem der Ansprüche 1 bis 4, dadurch gekennzeichnet, daß nur einzelne Leiterelemente in einer Leitereinheit mit von der Mitte (z = 0) zu ihren Enden (z = +L bzw. z = –L) abnehmendem Querschnitt vorgesehen sind, während mindestens ein Leiterelement dieser Leitereinheit einen konstanten Querschnitt aufweist.

6. Antenneneinrichtung nach einem der Ansprüche 1 bis 5, dadurch gekennzeichnet, daß die Leiterelemente (11, 12) in einem zumindest annähernd konstanten Abstand (a') ihrer Mittenachsen (14) bezüglich der Leiterhülle (3) angeordnet sind.

7. Antenneneinrichtung nach einem der Ansprüche 1 bis 5, gekennzeichnet durch Leiterelemente, deren Mittenachsen im Bereich der axialen Mitte (z = 0) der Einrichtung (10) einen kleineren Abstand gegenüber der Leiterhülle (3) haben als in den Bereichen ihrer stirnseitigen Enden (z = +L bzw. z = –L).

## Claims

1. Antenna system for exciting an at least substantially homogenous magnetic high frequency field and/or for receiving corresponding high frequency signals in a nuclear spin tomography device, having
— a hollow cylindrical conductor sheath (3) which is at least substantially transmissive at low frequency for magnetic gradient fields,
— at least two conductor units through which currents pass in opposite directions and which extend inside the conductor sheath (3) in the longitudinal direction of the device and respectively contain a conductor element or a conductor group,
— means at their end faces for reflecting the waves of the high frequency field and
— an external energy feeding and receiving device, characterised in that the conductor elements (11, 12) of the conductor units have at least partially a cross-section (q) which decreases at least substantially symmetrically from the axial centre (z = 0) to the end faces (z = +L or z = –L).

2. Antenna system according to claim 1, characterised in that there is provided a continuous and/or stepwise decrease in the electrically conductive cross-section (q) of the conductor elements (11, 12).

3. Antenna system according to claim 1 or 2, characterised in that the conductor elements (11, 12) have a double-conical shape.

4. Antenna system according to claim 1 or 2, characterised in that the conductor elements are strip-shaped.

5. Antenna system having conductor units respectively consisting of several conductor elements combined to form a group, according to one of claims 1 to 4, characterised in that only individual conductor elements in a conductor unit are provided with a cross-section decreasing from the centre (z = 0) to their ends (z = +L or z = –L), whilst at least one conductor element of this conductor unit has a constant cross-section.

6. Antenna device according to one of claims 1 to 5, characterised in that the conductor elements (11, 12) are arranged with their central axes (14) at an at least approximately constant distance (a') relative to the conductor sheath (3).

7. Antenna device according to one of claims 1 to 5, characterised by conductor elements whose central axes in the area of the axial centre (z = 0) of the device (10) have a smaller distance with respect to the conductor sheath (3) than in the areas of their end faces (z = +L or z = –L).

**Revendications**

1. Dispositif d'antenne pour l'excitation d'au moins un champ magnétique à haute fréquence, homogène au moins dans une large mesure, et/ou pour la réception de signaux correspondants à haute fréquence dans un appareil de tomographie à spin nucléaire, comportant

– une enveloppe conductrice cylindrique creuse (3), agencée de manière à laisser passer, au moins dans une large mesure, les basses fréquences pour des champs magnétiques irrotationnels,

– au moins deux unités de conducteurs qui sont parcourues par des courants dans des sens opposés qui s'étendent à l'intérieur de l'enveloppe conductrice (3) dans la direction longitudinale du dispositif et qui comportent chacune un élément conducteur ou un groupe de conducteurs,

– des moyens réfléchissant les ondes du champ à haute fréquence et montés aux extrémités frontales des unités de conducteurs, et

– un dispositif extérieur d'amenée et de réception d'une énergie, caractérisé par le fait que les éléments conducteurs (11, 12) des unités de conducteurs possèdent au moins en partie une section transversale (q), qui diminue au moins dans une large mesure de façon symétrique depuis le centre axial (z = 0) en direction des extrémités frontales (z = +L et z = –L).

2. Dispositif d'antenne suivant la revendication 1, caractérisé par le fait qu'il est prévu une diminution continue et/ou échelonnée de la section transversale électriquement conductrice (q) des éléments conducteurs (11, 12).

3. Dispositif d'antenne suivant la revendication 1 ou 2, caractérisé par le fait que les éléments conducteurs (11, 12) sont réalisés avec une forme biconique.

4. Dispositif d'antenne suivant la revendication 1 ou 2, caractérisé par le fait que les éléments conducteurs sont réalisés sous la forme de bandes.

5. Dispositif d'antenne comportant des unités de conducteurs formées de plusieurs éléments conducteurs réunis en un groupe, suivant l'une des revendications 1 à 4, caractérisé par le fait qu'il est prévu uniquement des éléments conducteurs individuels dans une unité de conducteurs, possédant une section transversale qui diminue depuis le centre (z=0) en direction des extrémités (z = +L et z = –L) de cette unité, alors qu'au moins un élément conducteur des éléments conducteurs possède une section transversale constante.

6. Dispositif d'antenne suivant l'une des revendications 1 à 5, caractérisé par le fait que les éléments conducteurs (11, 12) sont disposés de sorte que la distance de leurs axes médians (14) par rapport à l'enveloppe conductrice (3) est au moins approximativement constante (a').

7. Dispositif d'antenne suivant l'une des revendications 1 à 5, caractérisé par des éléments conducteurs, dont les axes médians sont séparés de l'enveloppe conductrice (3) d'une distance plus faible dans la zone du centre axial (z = 0) du dispositif (10) que dans les zones des extrémités frontales (z = +L et z = –L) de cette enveloppe.

FIG 1

FIG 2

FIG 3